# EUROPÄISCHE PATENTSCHRIFT

(11) **EP 2 035 895 B1**
(45) Veröffentlichungstag und Bekanntmachung des Hinweises auf die Patenterteilung: **14.10.2020**
(21) Anmeldenummer: 07765467.1
(22) Anmeldetag: 18.06.2007
(51) Int. Cl.: G03F 7/09, G03F 7/095, G03F 7/20

(54) **FOTOPOLYMERISIERBARER SCHICHTENVERBUND ZUR HERSTELLUNG VON FLEXODRUCKELEMENTEN UND VERFAHREN ZUR HERSTELLUNG VON FLEXODRUCKELEMENTEN**
PHOTOPOLYMERISABLE LAYERED COMPOSITE FOR PRODUCING FLEXO PRINTING ELEMENTS AND METHOD TO PRODUCE FLEXO PRINTING ELEMENTS
COMPOSITE MULTI-COUCHE PHOTOPOLYMÉRISABLE DESTINÉ À LA PRODUCTION D'ÉLÉMENTS D'IMPRESSION FLEXOGRAPHIQUE ET PROCÉDÉ DE FABRICATION D'ÉLÉMENTS D'IMPRESSION FLEXOGRAPHIQUE

(30) Priorität: 22.06.2006 DE 102006028640
(43) Veröffentlichungstag der Anmeldung: 18.03.2009
(73) Patentinhaber: Flint Group Germany GmbH, 70469 Stuttgart (DE)
(72) Erfinder: BECKER, Armin, 67259 Grossniedesheim (DE); STEBANI, Uwe, 67592 Flörsheim-dalsheim (DE); SCHADEBRODT, Jens, 55129 Mainz (DE); KRAUSS, Uwe, 76857 Gosserweiler-Stein (DE)
(74) Vertreter: Arnold & Siedsma
(86) Internationale Anmeldenummer: PCT/EP2007/056019
(87) Internationale Veröffentlichungsnummer: WO 2007/147803

(56) Entgegenhaltungen:
- EP-A- 0 251 228
- WO-A-2004/092841
- DE-A1- 3 704 694
- FR-A- 2 213 513
- JP-A- 2001 065 582
- JP-A- 2003 083 480
- DATABASE WPI Week 199140 Derwent Publications Ltd., London, GB; AN 1991-290947 XP002458146 & JP 03 192359 A (NIPPON ZEON KK) 22. August 1991 (1991-08-22)

## Beschreibung

Die Erfindung betrifft einen fotopolymerisierbaren Schichtenverbund zur Herstellung von fotopolymerisierbaren zylindrischen, endlos-nahtlosen Flexodruckelementen, sowie ein Verfahren zur Herstellung der fotopolymerisierbaren zylindrischen, endlos-nahtlosen Flexodruckelementen durch Aufbringen des Schichtenverbundes auf einen Hohlzylinder.

Zylindrische Flexodruckformen sind prinzipiell bekannt. Bei einer zylindrischen Flexodruckform ist der Druckzylinder der Druckmaschine im gesamten Umfang mit einer Druckschicht bzw. einem Druckrelief versehen. Zylindrische Druckformen besitzen große Bedeutung für den Druck von Endlos-Mustern und werden beispielsweise zum Drucken von Tapeten, Dekorpapieren oder Geschenkpapieren verwendet. Sie werden jedoch auch für den Druck nicht endloser Motive verwendet, um mittels einer geschickten Anordnung mehrer Nutzen eine möglichst hohe Wirtschaftlichkeit des Drucks zu erzielen.

Im Prinzip kann der eigentliche Druckzylinder der Druckmaschine selbst mit einer vollständig umhüllenden Druckschicht versehen werden. Diese Vorgehensweise hat jedoch den Nachteil, dass beim Wechsel der Druckform u.U. der gesamte Druckzylinder ausgetauscht werden muss. Dies ist äußerst aufwendig und dementsprechend teuer. Üblich ist daher die Verwendung sogenannter Sleeves. Bei Sleeves handelt es sich um einen zylindrischen Hohlkörper, auch als Hülse bezeichnet, der mit einer Druckschicht bzw. einem Druckrelief versehen worden ist. Die Sleeve-Technik ermöglicht einen sehr schnellen und einfachen Wechsel der Druckform. Der Innendurchmesser der Sleeves entspricht dem Außendurchmesser des Druckzylinders, so dass die Sleeves einfach über den Druckzylinder der Druckmaschine geschoben werden können. Das Auf- und Abschieben der Sleeves funktioniert nach dem Luftkissenprinzip: Für die Sleeve-Technologie ist die Druckmaschine mit einem speziellen Druckzylinder, einem sogenannten Luftzylinder, ausgestattet. Der Luftzylinder verfügt über einen Druckluftanschluss an der Stirnseite, mit dem Druckluft in das Innere des Zylinders geleitet werden kann. Von dort aus kann sie über an der Außenseite des Zylinders angeordnete Löcher wieder austreten. Zur Montage eines Sleeves wird Druckluft in den Luftzylinder eingeleitet und tritt an den Austrittslöchern wieder aus. Der Sleeve kann nun auf den Luftzylinder aufgeschoben werden, weil er sich unter dem Einfluss des Luftkissens geringfügig dehnt und das Luftkissen die Reibung deutlich vermindert. Wenn die Druckluftzufuhr beendet wird, geht die Dehnung zurück und der Sleeve sitzt auf der Oberfläche des Luftzylinders fest. Weitere Einzelheiten zur Sleeve-Technik sind beispielsweise offenbart in "Technik des Flexodrucks", S. 73 ff., Coating Verlag, St. Gallen, 1999.

Qualitativ hochwertige Runddruckformen können jedoch nicht hergestellt werden, indem man den Druckzylinder oder eine Hülse einfach mit einer bereits druckfertig verarbeiteten Flexodruckplatte vollständig umhüllt. An den zusammenstoßenden Enden der Druckplatte verbleibt nämlich ein feiner Spalt, welcher bei echten Endlos-Motiven oder versetzten Nutzen immer auch druckende Bereiche der Platte durchschneidet (von versetzten Nutzen spricht man, wenn über die Breite der Druckform mehrere Motive (Nutzen) angeordnet sind und diese in Druckrichtung versetzt sind). Dieser Spalt führt zu einer deutlich sichtbaren Linie im Druckbild. Um diese Linie zu vermeiden, dürfen sich an dieser Stelle nur nichtdruckende Vertiefungen befinden, somit können nicht beliebige Muster gedruckt werden. Außerdem besteht bei dieser Technik die Gefahr, dass das in der Druckfarbe enthaltene Lösungsmittel in den Spalt eindringen und die Enden der Druckplatte vom Druckzylinder loslösen kann. Dies führt zu noch stärkeren Störungen im Druckbild. Auch bei einem Verkleben der Enden verbleiben noch deutlich sichtbare Spuren im Druckbild.

Zur Herstellung qualitativ hochwertiger Runddruckformen ist es daher erforderlich, den Druckzylinder oder eine Hülse mittels geeigneter Techniken mit einer vollständig umhüllenden, reliefbildenden, fotopolymerisierbaren Schicht zu versehen. Dies kann beispielsweise durch Beschichten aus Lösung oder durch Ringextrusion erfolgen. Beide Techniken sind jedoch äußerst aufwendig und daher entsprechend teuer. Insbesondere muss bei diesen Techniken im Regelfall für jeden neuen Außendurchmesser ein eigenes, hochpräzises Werkzeug hergestellt und eingesetzt werden. Es ist daher weit verbreitet, den Druckzylinder oder die Hülse mit einer vorgefertigten, thermoplastisch verarbeitbaren Schicht aus fotopolymerisierbarem Material zu umwickeln und die zusammenstoßenden Kanten der fotopolymerisierbaren Schicht, auch Naht genannt, mittels geeigneter Techniken so gut wie möglich zu verschließen. Erst in einem zweiten Schritt wird das zylindrische fotopolymerisierbare Flexodruckelement zur fertigen Runddruckform verarbeitet. Geräte zur Verarbeitung zylindrischer Flexodruckelemente sind kommerziell erhältlich.

Bei der Herstellung von fotopolymerisierbaren Flexodruckelementen unter Verwendung von vorgefertigten Schichten ist es von besonderer Bedeutung, die Naht vollständig und mit äußerster Präzision zu verschließen. Die Bedeutung dieses Verfahrensschrittes hat in den letzten Jahren noch zugenommen. Moderne fotopolymerisierbare Flexodruckelemente, wie beispielsweise digital bebilderbare Flexodruckelemente, erlauben die Herstellung von Flexodruckformen mit deutlich höherer Auflösung als dies früher der Fall war. Flexodruck dringt daher auch zunehmend in solche Bereiche ein, die früher anderen Druckverfahren vorbehalten waren. Bei höherer Auflösung werden aber auch Fehler in der druckenden Oberfläche der Flexodruckform schneller sichtbar. Aus dem gleichen Grunde muss beim Aufbringen der fotopolymerisierbaren, reliefbildenden Schicht ebenfalls hohe Präzision gewährleistet sein. Dickenunterschiede in der reliefbildenden Schicht beeinträchtigen die Rundlaufgenauigkeit des Druckzylinders und damit die Druckqualität erheblich. Bei qualitativ hochwertigen Flexodruckformen sollte die Dickentoleranz üblicherweise nicht mehr als ± 10 µm betragen.

Fotopolymerisierbare, zylindrische Flexodruckelemente können beispielsweise hergestellt werden, indem man eine Schicht aus fotopolymerisierbarem Material auf eine Hülse aufbringt, so dass die Schnittkanten aneinander stoßen und anschließend auf ca. 160°C zu erhitzt, bis das Material zu schmelzen beginnt und die Schnittkanten ineinander verlaufen.

DE-A 29 11 980 offenbart ein Verfahren, bei dem ein Druckzylinder mit einer lichtempfindlichen Harzfolie umwickelt wird. Die Naht wird verschlossen, indem man den Druckzylinder mit einer Kalandrierwalze unter Drehen in Kontakt bringt, und die Schnittkanten durch Schmelzen miteinander verbindet.

Beim Schmelzen der fotopolymerisierbaren Schicht ist es jedoch kaum zu vermeiden, dass sich die Dicke der lichtempfindlichen Schicht unregelmäßig verändert. Die mit Hilfe derartiger Schmelzvorgänge hergestellten Druckzylinder oder Sleeves müssen daher nachgeschliffen und geglättet werden, um eine gute Oberfläche zu erhalten und Drucke in hoher Qualität zu gewährleisten. Darauf weist schon EP-A 469 375 hin. Außerdem können beim Schmelzen der Schicht leichtflüchtige Bestandteile der Schicht, wie z.B. Monomere, verdampfen, wodurch sich die Eigenschaften der Schicht nachteilig verändern können.

In DE-A 27 22 896 ist vorgeschlagen worden, ein handelsübliches, flächenförmiges, fotopolymerisierbares Flexodruckelement mitsamt der Trägerfolie auf einen Druckzylinder oder eine Hülse zu kleben, so dass die Schnittkanten aneinander stoßen. Die Schnittkanten sind gerade und werden anschließend unter Druck und bei erhöhter Temperatur miteinander verschweißt. Das Verschweißen kann auch mit Hilfe einer beheizten Kalandrierwalze erfolgen, indem der Druckzylinder unter Druck in Berührung mit der Kalandrierwalze in Drehung versetzt wird, bis sich die Enden miteinander verbinden. Die Verwendung einer Platte mit Trägerfolie ist jedoch äußerst problematisch.

Typische Trägerfolien weisen eine Dicke von 0,1 bis 0,25 mm auf. Soweit die Trägerfolie den Umfang nicht vollständig bedeckt und aufgrund eines kleinen Montage- oder Zuschnittfehlers auch nur minimal auseinander klafft, füllt sich der zwischen den Folienenden bestehende Leerraum beim Kalandrieren mit polymerem Material, und an der Oberfläche der fotopolymerisierbaren Schicht verbleibt ein Abdruck dieses Spaltes, der zu sichtbaren Störungen im Druck führt. Daher muss auch ein derartiges Flexodruckelement im Regelfalle nachgeschliffen und geglättet werden,

DE 3704694 A1 offenbart ein Verfahren zum Beschichten eines Formzylinders oder einer Formzylinder-Hülse mit einer endlosen lichtempfindlichen Aufzeichnungsschicht.

In WO 2004/092841 wird daher ein verbessertes Verfahren zur Herstellung von zylindrischen, endlos-nahtlosen, fotopolymerisierbaren Flexodruckelementen vorgeschlagen, welches einen besseren Verschluss der Naht als bei den bekannten Technologien sowie eine sehr gute Rundlaufgenauigkeit gewährleistet. Der erzielbare Nahtverschluss ist sehr gut, ein Nacharbeiten des erhaltenen Flexodruckelementes durch aufwendige Schleif- und Glättvorgänge ist überflüssig. Das Verfahren umfasst dabei die folgenden Schritte:
(a) Bereitstellen eines Schichtenverbundes mindestens umfassend eine Schicht aus einem fotopolymerisierbaren Material sowie eine von der Schicht abziehbare Trägerfolie,
(b) Zurechtschneiden der zu verbindenden Kanten des Schichtenverbundes mittels Gehrungsschnitten
(c) Aufschieben und Arretieren des Hohlzylinders auf einen drehbar gelagerten Trägerzylinder,
(d) Aufbringen einer Haftschicht auf die äußere Fläche des Hohlzylinders,
(e) Aufbringen des zurechtgeschnittenen Schichtenverbundes mit der von der temporären Trägerfolie abgewandten Seite auf den mit der Haftschicht versehenen Hohlzylinder, wobei die mit dem Gehrungsschnitt versehenen Enden im wesentlichen aufeinander liegen, aber nicht überlappen,
(f) Abziehen der Trägerfolie von der Schicht aus fotopolymerisierbarem Material,
(g) Verbinden der Schnittkanten bei einer Temperatur unterhalb der Schmelztemperatur der fotopolymerisierbaren Schicht, indem man die Oberfläche der fotopolymerisierbaren Schicht auf dem Hohlzylinder mit einer sich drehenden Kalanderwalze in Kontakt bringt, bis die Schnittkanten miteinander verbunden sind,
(h) Abziehen des bearbeiteten Hohlzylinders vom Trägerzylinder.

Bei dem Verfahren der WO 2004/092841 wird also eine Schicht eines fotopolymerisierbaren Materials ohne Trägerfolie mittels Haftschicht auf die äußere Fläche eines Hohlzylinders aufgebracht, deren Schichtenden dann anschließend durch Kalandrieren spaltfrei verbunden werden. Der Verzicht auf eine Trägerfolie ist dabei aus mehreren Gründen notwendig:
(1) Verwendet man eine fotopolymere Schicht mit Trägerfolie (in der Regel eine PET-Folie, die bei den zum Kalandrieren verwendeten Temperaturen keinen messbaren Schmelzflussindex zeigt) so führen bereits kleinste Montage- oder Zuschnittfehler zu einer Lücke (Aufklaffen) bzw. zu einem Überlappen der Trägerfolienenden. Kommt es zum Aufklaffen, so kann sich der dann zwischen den beiden Folienenden bestehende Leerraum zwar beim Kalandrieren mit polymerem Material füllen, an der Oberfläche der fotopolymerisierbaren Schicht verbleibt jedoch ein Abdruck dieses Spaltes, der zu sichtbaren Störungen im Druck führt. Kommt es zu einem Überlapp der beiden Folienenden, so führt dies an der Oberfläche der Druckform zu einem fühlbaren und im Druck sichtbaren Stoß. Verwendet man dagegen eine Schicht eines fotopolymerisierbaren Materials ohne Trägerfolie, so werden Montage- oder Zuschnittfehler durch die Fließfähigkeit des Materials bei der Verarbeitungstemperatur kompensiert. Es entsteht weder ein Spalt, noch ein Stoß. Das Druckverhalten an dieser Stelle unterscheidet sich nicht von dem in den übrigen Bereichen der Druckform.
(2) Montiert man eine Schicht eines fotopolymerisierbaren Materials mit Trägerfolie auf einen Hohlzylinder mit einem geringen Durchmesser, so kommt es aufgrund der starren Trägerfolie zu einem Aufstellen der Plattenenden, dem sogenannten Aufschnabeln. Eine Schicht eines fotopolymerisierbaren Materials ohne Trägerfolie ist dagegen deutlich flexibler, so dass sich selbst geringste Sleevedurchmesser problemlos belegen lassen.
(3) Eine Trägerfolie ändert sowohl das Deformations- und Rückstellverhalten, als auch das Druckverhalten der Druckform. In der Regel führt eine starre Folie unter der fotopolymeren Schicht zu einer höheren Tonwertzunahme und zu einer schlechteren Flächendeckung.

Neben den genannten Vorteilen erweist sich der Verzicht auf eine stabilisierende Trägerfolie aber auch als nachteilig.
(1) Die in WO 2004/092841 beschriebene Haftschicht ist ein doppelseitiges Klebeband, welches vor der Plattenmontage auf den Holzzylinder aufgebracht wird. Es kann sich dabei um ein einfaches Folienklebeband mit einer Dicke von beispielsweise 0,1 mm, oder um ein Schaumklebeband handeln. Letztere haben typische Dicken von 0,38 oder 0,55 mm. Bei der Verwendung eines Klebebands als Haftschicht führen jedoch auch hier bereits minimale Montage- oder Zuschnittfehler zu einem Leerraum zwischen den beiden Kanten des Klebebands. Dieser füllt sich beim Kalandrieren mit fotopolymerem Material, an der Oberfläche der fotopolymerisierbaren Schicht verbleibt ein Abdruck dieses Spaltes, der zu sichtbaren Störungen im Druck führt. Verwendet man ein Schaumklebeband, so kann sich noch ein zusätzliches Problem ergeben, da während des Zuschneidens die Zellen des Schaumstoffs entlang der Schnittkante zerschnitten (zerstört) werden. Dies kann je nach Art des verwendeten Schaumstoffs zu einem Einsinken des Schaums an dieser Stelle führen, so dass es im Vergleich zur restlichen Druckform zu einem unterschiedlichen Deformations- und Rückstellverhalten und damit auch einem unterschiedlichen Druckverhalten kommt. Montiert man dagegen eine auf einer Trägerfolie befindliche fotopolymere Schicht, so werden diese Probleme durch die starre Polyesterträgerfolie zwischen fotopolymerer Schicht und Klebeband eliminiert.
(2) Als ebenfalls nachteilig erweist sich die zu geringe Haftung zwischen fotopolymerer Schicht und Haftschicht. Durch eine zu geringe Haftung kann es zum Einschluss von Luftblasen zwischen Haftschicht und fotopolymerer Schicht kommen, die herzustellende nahtlos-endlose Druckform wird dadurch unbrauchbar. Die geringe Haftung kann zwar durch einen höheren Anpressdruck bei der Montage der Platte teilweise kompensiert werden, ein höherer Anpressdruck führt jedoch zu einer unerwünschten Längung der Platte. Somit wäre eine höhere Haftung zwischen Haftschicht und fotopolymerer Schicht wünschenswert.
(3) Ein weiterer Nachteil dieser in WO 2004/092841 beschriebenen Druckform wird im Druck ersichtlich, es kommt nämlich aufgrund der fehlenden starren Trägerfolie zu Anlaufkanten im Druck.

Aufgabe der vorliegenden Erfindung ist es, für das in WO 2004/092841 beschriebene Verfahren ein Material bereitzustellen, welches die beschriebenen Nachteile nicht aufweist.

Überraschenderweise konnte dies durch den Einsatz eines Schichtenverbundes umfassend mindestens eine reliefbildende Schicht aus einem fotopolymerisierbaren Material und eine darunterliegende härtere, schmelzbare Trägerschicht, gelöst werden. Dies ist insbesondere für den Fachmann überraschend, da es normalerweise beim Drucken vorteilhaft ist, wenn die Oberfläche einer Druckform härter ist als die darunter befindliche Schicht.

Gelöst wird die Aufgabe durch ein Verfahren zur Herstellung von fotopolymerisierbaren zylindrischen, endlos-nahtlosen Flexodruckelementen, bei dem man als Ausgangsmaterial einen Schichtenverbund umfassend mindestens
b) eine gegebenenfalls fotopolymerisierbare elastomere Trägerschicht, mindestens enthaltend ein elastomeres Bindemittel, gegebenenfalls ethylenisch ungesättigte Monomere und einen Fotoinitiator sowie gegebenenfalls weitere Additive,
c) eine fotopolymerisierbare reliefbildende Schicht, mindestens enthaltend ein elastomeres Bindemittel, ethylenisch ungesättigte Monomere und einen Fotoinitiator sowie gegebenenfalls weitere Additive,
wobei jeweils im fotopolymerisierten Zustand die reliefbildende Schicht c) eine Härte von 30 bis 70° Shore A (nach DIN) aufweist und die elastomere Trägerschicht b) eine Härte von 75° Shore A bis 70° Shore D (nach DIN) aufweist, wobei die Trägerschicht b) eine um mindestens 5° Shore A größere Härte als die reliefbildende Schicht c) aufweist, und wobei die Bestimmung der Shore-Härte entsprechend DIN 53505 an einem Stapel von sechs 1 mm dicken Schichten erfolgt, die durch 15-minütiges vollflächiges Belichten mit UVA-Licht fotopolymerisiert worden sind,
einsetzt, und wobei das Verfahren die folgenden Schritte umfasst:
(i) Zurechtschneiden der zu verbindenden Kanten des Schichtenverbundes mittels Gehrungsschnitten,
(ii) Aufschieben und Arretieren eines Hohlzylinders auf einen drehbar gelagerten Trägerzylinder,
(iii) Aufbringen einer Haftschicht auf die äußere Fläche des Hohlzylinders,
(iv) Aufbringen des zurechtgeschnittenen Schichtenverbundes, gegebenenfalls nach Abziehen einer Trägerfolie, mit der elastomeren Trägerschicht b) auf den mit der Haftschicht versehenen Hohlzylinder, wobei die mit dem Gehrungsschnitt versehenen Enden im Wesentlichen aufeinander liegen, aber nicht überlappen,
(v) gegebenenfalls Abziehen einer Deckfolie von der fotopolymerisierbaren reliefbildenden Schicht c),
(vi) Verbinden der Schnittkanten, indem man die Oberfläche der fotopolymerisierbaren Schicht auf dem Hohlzylinder unter Erwärmen mit einer sich drehenden Kalanderwalze in Kontakt bringt, bis die Schnittkanten miteinander verbunden sind,
(vii) Abziehen des bearbeiteten Hohlzylinders vom Trägerzylinder.

Gelöst wird die Aufgabe auch durch einen Schichtenverbund umfassend
a) auf einem Hohlzylinder eine Haftschicht,
b) auf der Haftschicht eine gegebenenfalls fotopolymerisierbare elastomere Trägerschicht, mindestens enthaltend ein elastomeres Bindemittel, gegebenenfalls ethylenisch ungesättigte Monomere und einen Fotoinitiator sowie gegebenenfalls weitere Additive,
c) auf der Trägerschicht eine fotopolymerisierbare reliefbildende Schicht, mindestens enthaltend ein elastomeres Bindemittel, ethylenisch ungesättigte Monomere und einen Fotoinitiator sowie gegebenenfalls weitere Additive,
wobei jeweils im fotopolymerisierten Zustand die reliefbildende Schicht c) eine Härte von 30 bis 70° Shore A (nach DIN) aufweist und die elastomere Trägerschicht b) eine Härte von 75° Shore A bis 70° Shore D (nach DIN) aufweist, wobei die Schicht b) eine um mindestens 5° Shore A größere Härte als die Schicht c) aufweist, und wobei die Bestimmung der Shore-Härte entsprechend DIN 53505 an einem Stapel von sechs 1 mm dicken Schichten erfolgt, die durch 15-minütiges vollflächiges Belichten mit UVA-Licht fotopolymerisiert worden sind.

Der Schichtenverbund zur Herstellung von fotopolymerisierbaren zylindrischen, endlos-nahtlosen Flexdodruckelementen kann weitere Schichten aufweisen. Beispielsweise kann der Schichtenverbund, in der Abfolge (1) - (6), wie folgt aufgebaut sein:
(1) eine Trägerfolie
(2) optional eine Entklebungsschicht
(3) die elastomere Trägerschicht b)
(4) die reliefbildende Schicht c)
(5) optional eine Entklebungsschicht
(6) eine Deckfolie.

Der erfindungsgemäß verwendete Schichtenverbund kann eine Trägerfolie umfassen. Bevorzugt ist diese aus Polyethylenterephthalat (PET) oder Polyethylennaphthalat (PEN). Diese kann zur besseren Abziehbarkeit auf geeignete Weise behandelt sein, beispielsweise durch Silikonisierung oder durch Beschichten mit einer geeigneten Entklebungsschicht (release layer). Derartige Entklebungsschichten können beispielsweise aus Polyamiden oder Polyvinylalkoholen bestehen.

Auf der gegebenenfalls mit der Entklebungsschicht beschichteten Trägerfolie befindet sich die elastomere Trägerschicht b). Diese weist eine Härte auf, welche größer ist als die Härte der reliefbildenden Schicht c). Die Trägerschicht b) weist unter Verarbeitungsbedingungen Schmelzbarkeit und Fließfähigkeit auf und weist eine ausreichend hohe Haftung zu der auf dem Hohlzylinder aufgebrachten Haftschicht bzw. zu dem Klebeband auf, auch nach Belichtung oder Rückseitenvorbelichtung. Die Trägerschicht kann optional fotochemisch vernetzbar sein.

Die elastomere Trägerschicht b) ersetzt auch die fehlende Trägerfolie im Hinblick auf deren mechanischen Eigenschaften. So kommt es trotz der fehlenden starren Trägerfolie nicht zu einer verstärkten Bildung von Anlaufkanten im Druck. Sie ist jedoch - im Gegensatz zu einer Trägerfolie - unter den Verarbeitungsbedingungen schmelzbar und fließfähig. Auch weist die Trägerschicht eine höhere Haftung zu der auf den Hohlzylinder aufgebrachten Haftschicht auf als die fotopolymerisierbare reliefbildende Schicht. Der Tapespalt wird aufgrund der Härte und Steifheit der Trägerschicht überbrückt.

Auf der elastomeren Trägerschicht b) befindet sich die fotopolymerisierbare reliefbildende Schicht c).

Sowohl die fotopolymerisierbare reliefbildende Schicht c) als auch die elastomere Trägerschicht b) enthalten mindestens ein elastomeres Bindemittel.

Elastomere Bindemittel zur Herstellung von Flexodruckelementen sind dem Fachmann bekannt. Es können sowohl hydrophile als auch hydrophobe Bindemittel eingesetzt werden. Als Beispiele seien Ethylen-Acrylsäure-Copolymere, Polyethylenoxid-Polyvinylalkohol-Propfcopolymere, Naturkautschuk, Polybutadien, Polyisopren, Styrol-Butadien-Kautschuk, Nitril-Butadien-Kautschuk, Butyl-Kautschuk, Styrol-Isopren-Kautschuk, Styrol-Butadien-Isopren-Kautschuk, Polynorbornen-Kautschuk oder Ethylen-Propylen-Dien-Kautschuk (EPDM) genannt. Bevorzugt werden hydrophobe Bindemittel eingesetzt. Derartige Bindemittel sind in organischen Lösemitteln löslich oder zumindest quellbar, während sie in Wasser weitgehend unlöslich sind und auch nicht oder zumindest nicht wesentlich in Wasser quellbar sind.

Bevorzugt handelt es sich bei dem Elastomer um ein thermoplastisch elastomeres Blockcopolymer aus Alkenylaromaten und 1,3-Dienen. Bei den Blockcopolymeren kann es sich sowohl um lineare, verzeigte oder radiale Blockcopolymere handeln. Üblicherweise handelt es sich um Dreiblockcopolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymerer eingesetzt werden. Handelsübliche Dreiblockcopolymere enthalten häufig gewisse Anteile an Zweiblockcopolymeren. Die Dien-Einheiten können 1,2- oder 1,4-verknüpft sein. Es können sowohl Blockcopolymere vom Styrol-Butadien oder vom Styrol-Isopren-Typ, als auch vom Styrol-Butadien-Isopren-Typ eingesetzt werden. Sie sind beispielsweise unter dem Namen Kraton® im Handel erhältlich. Weiterhin einsetzbar sind auch thermoplastisch elastomere Blockcopolymere mit Endblöcken aus Styrol und einem statistischen Styrol-Butadien-Mittelblock, die unter dem Namen Styroflex® erhältlich sind. Die Blockcopolymere können auch ganz oder teilweise hydriert sein, wie beispielsweise in SEBS-Kautschuken.

Ganz besonders bevorzugt in der fotopolymerisierbaren reliefbildenden Schicht c) enthaltene elastomere Bindemittel sind Dreiblockcopolymere vom Typ A-B-A oder radiale Blockcopolymere vom Typ (AB)ₙ, worin A Styrol und B ein Dien sind.

Ganz besonders bevorzugt in der elastomeren Trägerschicht b) enthaltene elastomere Bindemittel sind Dreiblockcopolymere vom Typ A-B-A, radiale Blockcopolymere vom Typ (AB)ₙ, worin A Styrol und B ein Dien sind, sowie statistische Copolymere und Random-Copolymere aus Styrol und einem Dien.

Selbstverständlich können auch Gemische mehrerer Bindemittel eingesetzt werden, vorausgesetzt, die Eigenschaften der reliefbildenden Schicht werden dadurch nicht negativ beeinflusst.

Die Gesamtmenge an Bindemitteln beträgt im Falle der reliefbildenden Schicht c) üblicherweise 40 bis 90 Gew.-% bezüglich der Summe aller Bestandteile der reliefbildenden Schicht, bevorzugt 40 bis 80 Gew.-% und besonders bevorzugt 45 bis 75 Gew.-%. Im Falle der elastomeren Trägerschicht b) kann die Gesamtmenge an elastomeren Bindemitteln bis zu 100 Gew.-% betragen. Üblicherweise beträgt sie 75 bis 100 Gew.-%, bevorzugt 85 bis 100 Gew.-% und besonders bevorzugt 90 bis 100 Gew.-%.

Die fotopolymerisierbare reliefbildende Schicht c) umfasst weiterhin in bekannter Art und Weise ethylenisch ungesättigte Monomere. Die Monomeren sind mit den Bindemitteln verträglich und weisen mindestens eine polymerisierbare, ethylenisch ungesättigte Doppelbindung auf. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure oder Allylverbindungen erwiesen. Beispiele für geeignete Monomere sind Butylacrylat, 2-Ethylhexylacrylat, Laurylacrylat, 1,4-Butandioldiacrylat, 1,6-Hexandioldiacrylat, 1,6-Hexandioldimethacrylat, 1,9-Nonandioldiacrylat, Trimethylolpropantri(meth)acrylat, Dioctylfumarat, N-Dodecylmaleimid. Ganz besonders bevorzugte Monomere sind Mono-, Di- und Triacrylate sowie -methacrylate. Selbstverständlich können auch Gemische mehrerer verschiedener Monomere eingesetzt werden. Art und Menge der Monomeren werden vom Fachmann je nach den gewünschten Eigenschaften der Schicht gewählt. Die Menge an Monomeren beträgt in der photopolymerisierbaren reliefbildenden Schicht c) im Regelfalle nicht mehr als 20 Gew.-% bzgl. der Menge aller Bestandteile, im Allgemeinen liegt sie zwischen 3 und 15 Gew.-%.

Die fotopolymerisierbare reliefbildende Schicht umfasst weiterhin in prinzipiell bekannter Art und Weise mindestens einen Fotoinitiator oder ein Fotoinitiatorsystem. Beispiele für geeignete Initiatoren sind Benzoin oder Benzoinderivate, wie Methylbenzoin oder Benzoinether, Benzilderivate, wie Benzilketale, Acylarylphosphinoxide, Acylarylphosphinsäureester, Mehrkernchinone oder Benzophenone. Die Menge an Fotoinitiator in der reliefbildenden Schicht beträgt in der Regel 0,1 bis 5 Gew.-% bezüglich der Menge aller Bestandteile der reliefbildenden Schicht.

Die elastomere Trägerschicht b) kann ebenfalls die genannten ethylenisch ungesättigten Monomere und die genannten Fotoinitiatoren enthalten, bevorzugt enthält sie diese, ist also wie die reliefbildende Schicht fotopolymerisierbar. Im Allgemeinen beträgt die Menge an ethylenisch ungesättigten Monomeren in der Trägerschicht 0 bis 15 Gew.-%. Im Allgemeinen beträgt die Menge an Fotoinitiator in der Trägerschicht 0 bis 5 Gew.-%.

Die reliefbildende Schicht c) und/oder die elastomere Trägerschicht b) können optional Weichmacher enthalten. Es können auch Gemische verschiedener Weichmacher eingesetzt werden. Beispiele für geeignete Weichmacher umfassen modifizierte und unmodifizierte Naturöle und -harze, wie hochsiedende paraffinische, naphthenische oder aromatische Mineralöle, synthetische Oligomere oder Harze wie Oligostyrol, hochsiedende Ester, oligomere Styrol-Butadien-Copolymere, oligomere α-Methylstyrol/p-Methylstyrol-Copolymere, flüssige Oligobutadiene, insbesondere solche mit einem Molekulargewicht zwischen 500 und 5000 g/mol, oder flüssige oligomere AcrylnitrilButadien-Copolymere oder oligomere Ethylen-Propylen-Dien-Copolymere. Bevorzugt sind Polybutadienöle (flüssige Oligobutadiene), insbesondere solche mit einem Molekulargewicht zwischen 500 und 5000 g/mol, hochsiedende aliphatische Ester wie insbesondere Alkylmono- und dicarbonsäureester, beispielsweise Stearate oder Adipate, und Mineralöle. Besonders bevorzugt sind hochsiedende, im Wesentlichen paraffinische und/oder naphthenische Mineralöle. Zum Beispiel sind sogenannte paraffinbasische Solvate und Spezialöle unter den Namen Shell Catenex® S und Shell Catenex® PH kommerziell erhältlich. Der Fachmann unterscheidet bei Mineralölen technische Weißöle, die noch einen sehr geringen Aromatengehalt aufweisen können, sowie medizinische Weißöle, die im Wesentlichen aromatenfrei sind. Sie sind kommerziell erhältlich und gleichermaßen gut geeignet. Die Menge eines optional vorhandenen Weichmachers wird vom Fachmann je nach den gewünschten Eigenschaften der Schicht bestimmt. Sie wird im Regelfalle 50 Gew.-% der Summe aller Bestandteile der fotopolymerisierbaren reliefbildende Schicht nicht übersteigen, im Allgemeinen beträgt sie 0 bis 50 Gew.-%, bevorzugt 0 bis 40 Gew.-%.

Der Weichmachergehalt in der Trägerschicht wird in der Regel 30 Gew.-% nicht übersteigen und beträgt im Allgemeinen 0 bis 20 Gew.-%, bevorzugt 0 bis 10 Gew.-%.

Die Härte der Schichten c) und b) lässt sich auf verschiedene Weise einstellen. Insbesondere lässt sie sich einstellen durch
1. die Art und Menge der elastomeren Bindemittel;
2. die Art und Menge der verwendeten Weichmacher;
3. die Art und Menge der ethylenisch ungesättigten Monomere.

Durch Wahl der exakten Zusammensetzung lässt sich die Härte der Schichten c) und b) innerhalb der oben definierten Bereiche wählen. Im Allgemeinen ist die elastomere Trägerschicht b) um mindestens 5° Shore A, bevorzugt um mindestens 10° Shore A härter als die reliefbildende Schicht c).

Als weitere Additive können in der elastomeren Trägerschicht b) enthalten sein: Haftverbesserer, Farbstoffe, Pigmente, Füllstoffe, Rheologieadditive, IR-Absorber und IR reflektierende Stoffe.

Die Dicke der reliefbildenden Schicht c) beträgt im Allgemeinen 0,3 bis 7 mm, bevorzugt 0,5 bis 4 mm. Die Dicke der elastomeren Trägerschicht b) beträgt im Allgemeinen 0,05 bis 0,25 mm, bevorzugt 0,075 bis 0,2 mm.

Auf der fotopolymerisierbaren reliefbildenden Schicht c) kann sich eine mit einer (optionalen) Entklebungsschicht beschichtete Deckfolie befinden, analog der oben beschriebenen Trägerfolie. Die Deckfolie ist vorzugsweise aus PET oder PEN und kann zur besseren Abziehbarkeit auf geeignete Weise, beispielsweise durch Silikonisierung, behandelt sein. Es kann auch eine Entklebungsschicht aus Polyamiden oder Polyvinylalkoholen vorgesehen sein.

Der Schichtenverbund lässt sich in bekannter Art und Weise nach verschiedenen Verfahren, beispielsweise durch Extrusion, Gießen oder Laminieren, in einem einstufigen oder mehrstufigen Produktionsprozess herstellen. Beispiel für einen einstufigen Produktionsprozess wäre die Coextrusion der fotopolymeren Schicht und der Trägerschicht zwischen die gegebenenfalls noch eine Entklebungsschicht enthaltenden Träger- bzw. Deckfolien. Ein mehrstufiger Prozess kann beispielsweise zwei Extrusionsschritte zur Extrusion der Trägerschicht und der fotopolymeren Schicht, zwei Gießschritte zum Gießen der Trägerschicht und der fotopolymeren Schicht, oder eine Kombination aus einem Extrusionsschritt (Trägerschicht oder fotopolymere Schicht) und einem Gießschritt (Trägerschicht oder fotopolymere Schicht) umfassen. Die Dicke des Schichtenverbundes beträgt in der Regel 0,3 bis 7 mm, bevorzugt 0,5 bis 4 mm und besonders bevorzugt 0,7 bis 2,5 mm.

Die Weiterverarbeitung des hergestellten Schichtenverbundes zu einer nahtlos-endlosen Druckform ist in WO 2004/092841 detailliert beschrieben, im Wesentlichen wird dabei wie folgt vorgegangen:
Herstellung der nahtlos-endlosen Druckform:
Die Trägerschicht b) kann optional vor dem Aufbringen auf den Hohlzylinder mit aktinischem Licht von der Rückseite her vorbelichtet werden. Die Vorbelichtung sollte im Regelfalle vor dem Zurechtschneiden des Schichtenverbundes erfolgen, um eine problemlose Verbindung der Schnittkanten zu gewährleisten. Anschließend werden die zu verbindenden Kanten des bereitgestellten Schichtenverbundes zurechtgeschnitten, dies wird üblicherweise mittels Gehrungsschnitten vorgenommen. Falls eine UVtransparente Hülse eingesetzt wird, kann die Vorbelichtung selbstverständlich auch erst nach dem Aufbringen des Schichtenverbunds auf die Hülse von der Innenseite der Hülse aus erfolgen.

Bei den verwendeten Hohlzylindern handelt es sich um übliche Hohlzylinder, die zur Montage auf Luftzylinder geeignet sind, d.h. sich unter dem Einfluss von Druckluft geringfügig dehnen können. Derartige Hohlzylinder werden auch als Hülsen oder manchmal auch als Sleeves, Basis-Sleeves oder dergleichen bezeichnet. Für die Zwecke dieser Erfindung sollen im Folgenden die als Träger verwendeten Hohlzylinder als Hülse beizeichnet werden, während der Begriff "Sleeve" für das Flexodruckelement als Ganzes, also inklusive der fotopolymerisierbareren Schicht, Klebeschicht und eventueller weiterer Schichten reserviert sein soll.

Anschließend werden die verwendeten Hohlzylinder zur Ausführung des erfindungsgemäßen Verfahrens auf einen drehbar gelagerten Trägerzylinder aufgeschoben und arretiert, so dass der Hohlzylinder mit dem Trägerzylinder fest verbunden ist und keine Bewegung relativ zueinander möglich ist. Der Trägerzylinder bietet einen festen Halt für den nachfolgenden Kalandrierprozess.

Danach wird die Haftschicht auf die äußere Fläche des Hohlzylinders aufgebracht. Die Haftschicht soll auch noch bei erhöhten Temperaturen, wie sie während des Kalandriervorganges herrschen, eine gute Haftung vermitteln. Sie soll insbesondere eine sehr gute Scherfestigkeit vermitteln, damit der Schichtenverbund während des Kalandriervorganges nicht auf der Oberfläche des Hohlzylinders verrutscht. Bei der Haftschicht kann es sich um einen geeigneten Haftlack handeln, der auf die Oberfläche des Hohlzylinders aufgetragen wird. Bevorzugt handelt es sich aber bei der Haftschicht um eine doppelseitige Klebefolie. Insbesondere kann es sich bei den Klebefolien um Schaumklebefolien handeln, welche zusätzlich eine dämpfende Schaumstoffschicht aufweisen.

Anschließend erfolgt das Aufbringen des fotopolymerisierbaren Schichtenverbunds auf den mit der Haftschicht versehenen Hohlzylinder. Nach dem Aufbringen des Schichtenverbunds wird eine eventuell vorhandene Deckfolie inklusive einer eventuell vorhandenen Entklebeschicht von der reliefbildenden Schicht c) abgezogen.

Danach werden die Schnittkanten verbunden. Zum Verbinden der Schnittkanten wird die Oberfläche des Schichtenverbunds auf dem Hohlzylinder mit einer sich drehenden Kalanderwalze in Kontakt gebracht, bis die Schnittkanten miteinander verbunden sind. Der Trägerzylinder und die Kalanderwalze drehen sich gegeneinander. Der notwendige Kalanderdruck wird vom Fachmann je nach der Art der fotopolymerisierbaren Schicht durch das Einstellen des Abstandes zwischen dem Trägerzylinder und der Kalanderwalze bestimmt. Die Kalandriertemperatur richtet sich nach der Art der fotopolymerisierbaren Schicht und den gewünschten Eigenschaften. Die Temperatur der Kalandrierwalze wird aber erfindungsgemäß so eingestellt, dass die Temperatur der fotopolymerisierbaren Schicht in jedem Falle unterhalb deren Schmelztemperatur liegt. Zweckmäßigerweise erfolgt die Wärmezufuhr, indem man eine von Innen beheizte Kalanderwalze, einen IR-Strahler oder warme Gasströme einsetzt. Selbstverständlich können Wärmequellen auch kombiniert werden. Im Regelfalle beträgt die Temperatur beim Kalandrieren 80 bis 130°C, bevorzugt 90 bis 120°C, jeweils gemessen an der Oberfläche der fotopolymerisierbaren Schicht. Im Regelfalle sind bis zu einem vollständigen Spaltverschluss ca. 15 min erforderlich, wobei diese Zeit natürlich auch von der gewählten Temperatur und dem Druck abhängt.

Nach dem Verschließen der Naht und gegebenenfalls Abkühlen wird der bearbeitete Hohlzylinder/fertige Sleeve wieder vom Trägerzylinder abgenommen.

Die Weiterverarbeitung zu Flexodruckformen kann nach verschiedenen Techniken erfolgen. Die Flexodruckelemente können beispielsweise auf prinzipiell bekannte Art und Weise bildmäßig belichtet, und die unbelichteten Bereiche der reliefbildenden Schicht c) anschließend mittels eines geeigneten Entwicklungsprozesses entfernt werden. Die bildmäßige Belichtung kann grundsätzlich durch Umhüllen des Sleeves mit einer fotografischen Maske und Belichten durch die Maske hindurch erfolgen.

Bevorzugt wird die Bebilderung aber mittels digitaler Masken vorgenommen. Derartige Masken sind auch als In-situ-Masken bekannt. Hierzu wird zunächst eine digital bebilderbare Schicht auf die fotopolymerisierbare reliefbildende Schicht c) des Sleeves aufgebracht.

Bevorzugt handelt es sich bei der digital bebilderbaren Schicht um eine Schicht, ausgewählt aus der Gruppe von IR-ablativen Schichten, Ink-Jet-Schichten oder thermografisch beschreibbaren Schichten.

IR-ablative Schichten bzw. Masken sind für die Wellenlänge des aktinischen Lichtes opak und umfassen üblicherweise ein Bindemittel sowie mindestens einen IR-Absorber wie beispielsweise Ruß. Ruß sorgt auch dafür, dass die Schicht opak ist. In die IR-ablative Schicht kann mittels eines IR-Lasers eine Maske eingeschrieben werden, d.h. die Schicht wird an den Stellen, an denen sie vom Laserstrahl getroffen wird, zersetzt und abgetragen. Beispiele für die Bebilderung von Flexodruckelementen mit IR-ablativen Masken sind beispielsweise in EP-A 654 150 oder EP-A 1 069 475 offenbart.

Bei Ink-Jet-Schichten wird eine mit Ink-Jet-Tinten beschreibbare, für aktinisches Licht durchlässige Schicht, beispielsweise eine Gelatine-Schicht aufgetragen. Auf diese wird mittels Ink-Jet-Druckern eine Maske mit opaker Tinte aufgetragen. Beispiele sind in EP-A 1 072 953 offenbart.

Bei thermografischen Schichten handelt es sich um Schichten, die Substanzen enthalten, die sich unter dem Einfluss von Hitze schwarz färben. Derartige Schichten umfassen beispielsweise ein Bindemittel und ein organisches Silbersalz und können mittels eines Druckers mit Thermokopf bebildert werden. Beispiele sind in EP-A 1 070 989 offenbart.

Die digital bebilderbaren Schichten können durch Lösen bzw. Dispergieren aller Bestandteile der jeweiligen Schicht in einem geeigneten Lösemittel und Aufbringen der Lösung auf die fotopolymerisierbare Schicht des zylindrischen Flexodruckelementes, gefolgt vom Verdampfen des Lösemittels, hergestellt werden. Das Aufbringen der digital bebilderbaren Schicht kann beispielsweise durch Aufsprühen oder mittels der in EP-A1 158 365 beschriebenen Technik erfolgen.

Nach dem Aufbringen der digital bebilderbaren Schicht wird diese mittels der jeweils geeigneten Technik bebildert und anschließend der Sleeve durch die gebildete Maske hindurch in prinzipiell bekannter Art und Weise mittels aktinischen Lichts bestrahlt. Als aktinisches, also chemisch "wirksames" Licht eignet sich in bekannter Art und Weise insbesondere UVA- bzw. UV/VIS-Strahlung. Rundbelichter zur gleichmäßigen Belichtung von Sleeves sind kommerziell erhältlich.

Das Entwickeln der bildmäßig belichteten reliefbildenden Schicht c) kann auf konventionelle Art und Weise mittels eines Lösemittels oder eines Lösemittelgemisches erfolgen. Dabei werden die nicht belichteten, d.h. die von der Maske abgedeckten Bereiche der Reliefschicht durch Auflösen im Entwickler entfernt, während die belichteten, d.h. die vernetzten Bereiche erhalten bleiben. Die Maske oder die Reste der Maske werden ebenfalls vom Entwickler entfernt, falls die Komponenten darin löslich sind. Falls die Maske nicht im Entwickler löslich ist, wird sie gegebenenfalls vor dem Entwickeln mit Hilfe eines zweiten Lösemittels entfernt.

Die Entwicklung kann auch thermisch erfolgen. Bei der thermischen Entwicklung wird kein Lösemittel eingesetzt. Stattdessen wird die reliefbildende Schicht nach der bildmäßigen Belichtung mit einem absorbierenden Material in Kontakt gebracht und erwärmt. Bei dem absorbierenden Material handelt es sich beispielsweise um ein poröses Vlies, beispielsweise aus Nylon, Polyester, Cellulose oder anorganischen Materialien. Es wird auf eine solche Temperatur erwärmt, dass sich die nicht polymerisierten Anteile der reliefbildenden Schicht verflüssigen und vom Vlies aufgesogen werden können. Das vollgesogene Vlies wird anschließend entfernt. Einzelheiten zur thermischen Entwicklung sind beispielsweise von US 3,264,103, US 5,175,072, WO 96/14603 oder WO 01/88615 offenbart. Die Maske kann gegebenenfalls vorher mittels eines geeigneten Lösemittels oder ebenfalls thermisch entfernt werden.

Die Herstellung von zylindrischen Flexodruckformen aus den fotopolymerisierbaren, endlos-nahtlosen Flexodruckelementen kann auch mittels Laser-Direktgravur vorgenommen werden. Bei diesem Verfahren wird die fotopolymerisierbare Schicht zunächst ohne Auflegen einer Maske vollständig im gesamten Volumen mittels aktinischen Lichts, Elektronenstrahlen oder γ-Strahlen vernetzt. Anschließend wird in die vernetzte Schicht mittels eines oder mehrerer Laser ein Druckrelief eingraviert.

Die vollflächige Vernetzung kann mit üblichen Rundbelichtern für Sleeves wie oben beschrieben erfolgen. Besonders vorteilhaft kann sie aber auch in Anlehnung an das in WO 01/39897 beschriebene Verfahren erfolgen. Hierbei wird in Anwesenheit eines Schutzgases, welches schwerer ist als Luft, beispielsweise CO₂ oder Ar belichtet. Das fotopolymerisierbare, zylindrische Flexodruckelement wird hierzu in ein mit Schutzgas gefülltes Tauchbecken abgesenkt, dessen Wände bevorzugt mit einem reflektierenden Material, beispielsweise Aluminium-Folie ausgekleidet sind. Die Füllung des Tauchbeckens mit Schutzgas kann beispielsweise so erfolgen, indem man Trockeneis in das Tauchbecken einbringt, welches beim Verdampfen den Luftsauerstoff verdrängt, oder aber man leitet zur Verdrängung des Sauerstoffs ein Gas mit einer höheren Dichte als Luft, beispielsweise Kohlendioxid oder Argon, in das Tauchbecken. Anschließend wird von oben her mittels aktinischen Lichts belichtet. Es können hierzu im Prinzip die üblichen UV- bzw. UV/VIS-Quellen für aktinisches Licht verwendet werden. Bevorzugt werden Strahlungsquellen eingesetzt, welche im Wesentlichen sichtbares Licht und keine oder nur geringe Anteile von UV-Licht emittieren. Bevorzugt sind Lichtquellen, die Licht mit einer Wellenlänge von mehr als 300 nm emittieren. Beispielsweise können übliche Halogenlampen verwendet werden. Das Verfahren hat den Vorteil, dass die bei kurzwelligen UV-Lampen übliche Ozon-Belastung nahezu vollständig unterbleibt, Schutzmaßnahmen gegen starke UV-Strahlung im Regelfalle unnötig sind und keine aufwendigen Apparaturen nötig sind. Somit kann dieser Verfahrensschritt besonders wirtschaftlich durchgeführt werden.

Bei der Laser-Direktgravur absorbiert die Reliefschicht Laserstrahlung in einem solchen Ausmaße, so dass sie an solchen Stellen, an denen sie einem Laserstrahl ausreichender Intensität ausgesetzt ist, entfernt oder zumindest abgelöst wird. Vorzugsweise wird die Schicht dabei ohne vorher zu schmelzen verdampft oder thermisch oder oxidativ zersetzt, so dass ihre Zersetzungsprodukte in Form von heißen Gasen, Dämpfen, Rauch oder kleinen Partikeln von der Schicht entfernt werden.

Zur Gravur der erfindungsgemäß eingesetzten reliefbildenden Schichten eignen sich insbesondere Laser, die eine Wellenlänge von 9000 nm bis 12 000 nm aufweisen. Zu nennen sind hier insbesondere CO₂-Laser. Die in der reliefbildenden Schicht verwendeten Bindemittel absorbieren die Strahlung derartiger Laser in ausreichendem Maße, um graviert werden zu können.

Vorteilhaft kann die erhaltene zylindrische Flexodruckform im Anschluss an die Lasergravur in einem weiteren Verfahrensschritt nachgereinigt werden. In manchen Fällen kann dies durch einfaches Abblasen mit Druckluft oder Abbürsten geschehen. Es ist aber bevorzugt, zum Nachreinigen ein flüssiges Reinigungsmittel einzusetzen um auch Polymerbruchstücke vollständig entfernen zu können. Geeignet sind beispielsweise wässrige Reinigungsmittel, welche im Wesentlichen aus Wasser sowie optional geringen Mengen von Alkoholen bestehen, und die zur Unterstützung des Reinigungsvorganges Hilfsmittel, wie beispielsweise Tenside, Emulgatoren, Dispergierhilfsmittel oder Basen enthalten können. Geeignet sind auch "Wasser-in-Öl"-Emulsionen, wie in EP-A 463 016 beschrieben.

Die Erfindung wird durch die nachstehenden Beispiele näher erläutert.

### Beispiele:

### Allgemeine Vorschrift zur Herstellung der eingesetzten Trägerschichten:

Die Herstellung der eingesetzten Trägerschichten erfolgte mittels Gießen aus toluolischer Lösung auf eine PET-Folie als Trägerfolie, welche mit einer 5 µm dicken Schicht aus dem Polyamid Makromelt 6900 als Entklebungsschicht beschichtet war.

### Allgemeine Vorschrift zur Herstellung der eingesetzten Schichtenverbunde:

Die Herstellung der erfindungsgemäß eingesetzten Schichtenverbunde erfolgt, indem die fotopolymerisierbare Masse extrudiert, durch eine Breitschlitzdüse ausgetragen und zwischen der Trägerschicht und der Deckfolie kalandriert wird. Das Extrusionsverfahren ist in EP-B 084 851 detailliert beschrieben. Als Trägerschicht werden die nachfolgend unter A) beschriebenen Trägerschichten eingesetzt, als Deckfolie wird eine mit 5 µm Makromelt 6900 beschichtet PET-Folie verwendet. Der Verbund aus Trägerschicht und photopolymerer Schicht weist eine Gesamtdicke von 1,14 mm auf.

### Allgemeine Vorschrift zur Herstellung einer nahtlos/endlosen Druckform:

Zur Ausführung dieses Verfahrensschrittes wird zunächst die mit dem Schichtenverbund zu belegende Hülse auf den Luftzylinder des Montagegeräts aufgeschoben. Dann wird die Klebefolie auf dem Montagetisch zurechtgeschnitten, der Luftzylinder in Drehung versetzt und die Folie langsam bis in den Spalt zwischen Hilfswalze und dem mit der Hülse versehenen Luftzylinder eingeschoben. Durch die Drehung wird die Klebefolie mitgenommen, wobei die Hilfswalze die Folie gleichmäßig auf die Hülse drückt, so dass die Klebefolie blasenfrei an der Hülse festklebt. Danach wird die Schutzfolie von der Klebfolie abgezogen. Die Hülse ist nun mit einer Haftschicht versehen. Im nächsten Schritt wird der zurechtgeschnittene fotopolymerisierbare Schichtenverbund nach Entfernung der Trägerfolie (optional inklusive Entklebungsschicht) in den Spalt eingeschoben, mitgenommen und von der Hilfswalze festgedrückt. Die Trägerschicht ist dabei zur Hülse hin gerichtet. Die Kalanderwalze und der mit Hülse, Haftschicht, Trägerschicht und fotopolymerisierbarer Schicht versehene Luftzylinder werden in Kontakt miteinander gebracht, in Drehung versetzt, und der Spalt durch Kalandrieren unter Wärmeeintrag verschlossen.

### Allgemeine Vorschrift zur Weiterverarbeitung der nahtlos/endlosen Druckform:

Mittels eines Ringcoaters werden die nahtlos/endlosen Druckformen mit einer digital bebilderbaren Schicht versehen. Die Beschichtung erfolgt mittels Ringcoater, als Beschichtungslösung wird eine DSL II 80 Lösung (Flint Group Germany GmbH) verwendet. Nach dem Aufbringen der digital bebilderbaren Schicht wird diese mittels der jeweils geeigneten Technik bebildert und der Sleeve anschließend durch die gebildete Maske hindurch in prinzipiell bekannter Art und Weise mittels aktinischen Lichts bestrahlt. Als aktinisches, also chemisch "wirksames" Licht eignet sich in bekannter Art und Weise insbesondere UVA- bzw. UV/VIS-Strahlung. Rundbelichter zur gleichmäßigen Belichtung von Sleeves sind kommerziell erhältlich.

Das Entwickeln der bildmäßig belichteten Schicht erfolgt auf konventionelle Art und Weise unter Verwendung des Auswaschmittels nylosolv® A (Flint Group Germany GmbH).

Verwendete Einsatzstoffe:

| | |
|---|---|
| Styroflex® 2G66: | SBS-Blockcopolymer (BASF AG) |
| Styrolux® 3G55: | SBS-Blockcopolymer (BASF AG) |
| Kraton® D-1102: | SBS-Blockcopolymer (Kraton Polymers) |
| Kraton® D-4150: | SBS-Blockcopolymer mit 33% Mineralöl (Kraton Polymers) |
| Polyöl® 130: | Oligobutadien, Weichmacher (Degussa) |
| Laromer® HDDA: | 1,6-Hexandioldiacrylat (BASF) |
| HDDMA: | 1,6-Hexandioldimethacrylat (Röhm GmbH & Co. KG) |
| Lucirin® BDK: | Benzildimethylketal (BASF) |
| Kerobit® TBK: | 2,6-Di-tert.-butyl-p-kresol (Raschig) |

### A) Herstellung der Trägerschichten

### Beispiel 1: Herstellung der Trägerschicht 1 (TS-1)

Die Trägerschicht 1 (TS-1) wurde wie in der allgemeinen Vorschrift beschrieben mit der in Tabelle 1 angegebenen Zusammensetzung hergestellt. Die Dicke der trockenen Trägerschicht betrug 75 µm.

**Tabelle 1: Zusammensetzung der Trägerschicht 1**

| Komponente | Menge |
|---|---|
| SBS-Blockcopolymer (Styroflex 2G66) | 94 % |
| Monomer Hexandioldimethacrylat | 5 % |
| Benzildimethylketal (Fotoinitiator) | 1 % |
| Summe | 100 % |

### Beispiel 2: Herstellung der Trägerschicht 2 (TS-2)

Die Trägerschicht 2 (TS-2) wurde wie in der allgemeinen Vorschrift beschrieben hergestellt. Die Zusammensetzung der Trägerschicht entsprach der der Trägerschicht 1, die Dicke der trockenen Trägerschicht betrug jedoch 125 µm.

### Beispiel 3: Herstellung der Trägerschicht 3 (TS-3)

Die Trägerschicht 3 (TS-3) wurde wie in der allgemeinen Vorschrift beschrieben mit der in Tabelle 2 angegebenen Zusammensetzung hergestellt. Die Dicke der trockenen Trägerschicht betrug 125 µm.

**Tabelle 2: Zusammensetzung der Trägerschicht 3**

| Komponente | Menge |
|---|---|
| SBS-Blockcopolymeres (Styrolux 3G55) | 94 % |
| Monomer Hexandioldimethacrylat | 5 % |
| Fotoinitiator | 1 % |
| Summe | 100 % |

### Vergleichsbeispiel 1: Trägerschicht 4 (TS-4)

Als Trägerschicht 4 wurde eine kommerziell verfügbare PET Folie der Dicke 175 µm verwendet.

### Vergleichsbeispiel 2: Trägerschicht 5 (TS-5)

Die Trägerschicht 5 wurde, wie in der allgemeinen Vorschrift beschrieben, mit der in Tabelle 3 angegebenen Zusammensetzung hergestellt. Die Dicke der trockenen Trägerschicht betrug 125 µm.

**Tabelle 3: Zusammensetzung der Trägerschicht 3**

| Komponente | Menge |
|---|---|
| Kraton® D-4150 | 74 % |
| Weichmacher Polyöl 130 | 20 % |
| Monomer Hexandioldimethacrylat | 5 % |
| Fotoinitiator | 1 % |
| Summe | 100 % |

### Beispiel 6: Bestimmung von Schmelzflussindices und Härte der hergestellten Trägerschichten

Zur Bestimmung der Schmelzflussindices und Härte der hergestellten Trägerschichten wurden die Trägerschichten 1, 2, 3 und 5 von ihrer Trägerfolie abgezogen. Die Trägerschicht 4 wurde wie erworben eingesetzt. Der Schmelzflussindex (MVR) wurde bei einer Temperatur von 80°C und einem Auflagegewicht von 5 kg gemäß DIN ISO 1133 bestimmt.

Die Messung der Shore A-Härte erfolgte entsprechend DIN 53 505. Hierfür wurden Schichten entsprechend den Beispielen in einer Dicke von 1 mm hergestellt und durch 15 minütiges vollflächiges Belichten mit UVA-Licht (Belichter F III, Flint Group Germany GmbH) vernetzt. Von jedem Schichttyp wurden jeweils 6 Stück der 1 mm dicken Schichten übereinander gestapelt, um eine Gesamtschichtdicke von 6 mm zu erzielen. Von den 6 mm dicken Schichtstapeln wurde die Härte mit einem Härtemessgerät (Typ U72 / 80E, Heinrich Bareiss Prüfgerätebau GmbH) gemäß DIN 53 505 ermittelt.

Die Ergebnisse sind in Tabelle 4 zusammengefasst. Zum Vergleich sind Schmelzflussindex und Härte der fotopolymeren Schicht ebenfalls angegeben.

**Tabelle 4: Schmelzflussindices der hergestellten Trägerschichten.**

| | TS-1 | TS-2 | TS-3 | TS-4 | TS-5 | FS |
|---|---|---|---|---|---|---|
| | | | | | | |

| **Schmelzflussindex** | | | | | | |
|---|---|---|---|---|---|---|
| MVR (5kg / 200°C), cm³ / 10 min. | 34 | 46 | 46 | 0 | > 150 | > 150 |
| | | | | | | |

| **Härte** | | | | | | |
|---|---|---|---|---|---|---|
| **Härte, °Shore A** | 94 | 99 | 99 | | 32 | 62 |
| | | | | | | |

| **Zug / Dehnungsversuch:** | | | | | | |
|---|---|---|---|---|---|---|
| Spannung im unbelichteten Zustand, | 17,3 | 18,3 | 14,4 | 125 | 0,3 | 0,2 |
| Spannung im belichteten Zustand, N/mm² | 18,1 | 22,7 | 21,5 | 125 | 1,8 | 5,8 |
| Dehnung im unbelichteten Zustand, N/mm² | 547 | 410 | 500 | 69 | 1070 | 290 |
| Dehnung im belichteten Zustand, N/mm² | 281 | 290 | 260 | 69 | 430 | 403 |
| E-Modul (@ 125%) im unbel. Zustand, % | 5,3 | 10,2 | 8,7 | n.b. | 0,1 | 0,1 |
| E-Modul (@ 125%) im bel. Zustand, % | 10,1 | 16,9 | 17,4 | n.b. | 0,5 | 2,2 |

| | | | | | | |
|---|---|---|---|---|---|---|
| TS = Trägerschicht FS = Fotopolymere Schicht | | | | | | |

### B) Herstellung der Schichtenverbunde

### Beispiele 7a - 7f:

Die Schichtenverbunde wurden wie in der allgemeinen Vorschrift beschrieben hergestellt. Dabei lag der fotopolymeren Schicht die in Tabelle 5 angegebene Rezeptur zu Grunde.

**Tabelle 5: Zusammensetzung der fotopolymeren Schicht**

| **Komponente** | **Menge** |
|---|---|
| SBS-Blockcopolymer (Kraton D 1102) | 55 % |
| Weichmacher (Polybutadienöl) | 32 % |
| Monomer (Hexandioldiacrylat) | 10 % |
| Benzildimethylketal (Fotoinitiator) | 2 % |
| Additive (thermischer Stabilisator, Farbstoff) | 1 % |
| Summe | 100 % |

Die fotopolymere Schicht wurde zwischen die gemäß A) hergestellten Trägerschichten und jeweils eine Deckfolie kalandriert. Als Deckfolien wurde jeweils eine mit 5 µm Makromelt 6900 beschichtete PET-Folie verwendet. Der Verbund aus Trägerschicht und photopolymerer Schicht hatte eine Gesamtdicke von 1,14 mm ohne Deckfolie und ohne Trägerfolie. Tabelle 6 gibt einen Überblick über die gefertigten Schichtenverbunde.

**Tabelle 6: Gefertigte Schichtenverbunde**

| | Trägerschicht | Photopolymere Schicht |
|---|---|---|
| Beispiel 7a | keine | PS-1 (1140 µm) |
| Beispiel 7b | TS 1 | PS-1 (1065 µm) |
| Beispiel 7c | TS 2 (125 µm Styroflex) | PS-1 (1015 µm) |
| Beispiel 7d | TS 3 (125 µm Styrolux) | PS-1 (1015 µm) |
| Beispiel 7e | TS 4 (PET Folie) | PS-1 (965 µm) |
| Beispiel 7f | TS 5 (125 µm Kraton D-4150) | PS-1 (1015 µm) |

Vergleichsbeispiele sind die Beispiele 7a (keine Trägerschicht), 7e (PET-Folie als Trägerschicht) sowie 7f (weiche fotopolymere Schicht). Die Haftung der herstellten Schichtenverbunde auf dem Schaumklebeband (Rogers SA2520) sind in Tabelle 7 gegenübergestellt.

**Tabelle 7: Eigenschaften der Schichtenverbunde**

| | Bsp. 7a Vergleich | Bsp. 7b | Bsp. 7c | Bsp. 7d | Bsp. 7e Vergleich | Bsp. 7f Vergleich |
|---|---|---|---|---|---|---|
| Haftung zum Schaumklebeband [N] | 0,1 | > 5 | > 5 | > 5 | > 5 | 0,3 |

Die Ergebnisse in Tabelle 7 zeigen, dass sich durch die Trägerschicht die mechanischen Eigenschaften der hergestellten Schichtenverbunde deutlich verbessern. Hervorzuheben ist zusätzlich die deutlich verbesserte Haftung zum Schaumklebeband.

### Herstellung der nahtlos/endlosen Druckformen:

Aus den in den Beispielen 7a - 7f hergestellten Schichtenverbunden wurden, wie in der allgemeinen Vorschrift beschrieben, nahtlos/endlose Druckformen hergestellt. Als Träger wurde eine Onyx-Hülse der Fa. Polywest eingesetzt, zur Fixierung des Schichtenverbundes auf der Hülse wurde ein doppelseitige Schaumklebeband (Rogers SA 2520) verwendet. Diese wurden mit einer digital bebilderbaren Schicht versehen, bebildert, belichtet, ausgewaschen, getrocknet und nachbehandelt.

### Druckversuche

Der Andruck der Druckform erfolgte auf einer W&H Druckmaschine, als Bedruckstoff wurde eine PE-Folie verwendet, die Druckgeschwindigkeit betrug 150 m/min. Tabelle 8 gibt die Qualität der Druckformen hinsichtlich des Auftretens von Tape- und Plattenspalt und des Auftreten von Anlaufkanten im Druckbild wieder.

**Tabelle 8: Qualität der Druckformen**

| Schichtenverbunde aus | Tapespalt | Platten spalt | Anlaufkante |
|---|---|---|---|
| Beispiel 7a (Vergleich) | sichtbar | nicht sichtbar | sichtbar |
| Beispiel 7b | nicht sichtbar | nicht sichtbar | nicht sichtbar |
| Beispiel 7c | nicht sichtbar | nicht sichtbar | nicht sichtbar |
| Beispiel 7d | nicht sichtbar | nicht sichtbar | nicht sichtbar |
| Beispiel 7e (Vergleich) | nicht sichtbar | sichtbar | nicht sichtbar |
| Beispiel 7f (Vergleich) | nicht sichtbar | nicht sichtbar | nicht sichtbar |

**Tabelle 7: Eigenschaften der Schichtenverbunde**

| | Bsp. 7a Vergleich | Bsp. 7b | Bsp. 7c | Bsp. 7d | Bsp. 7e Vergleich | Bsp. 7f Vergleich |
|---|---|---|---|---|---|---|
| Haftung zum Schaumklebeband [N] | 0,1 | > 5 | > 5 | > 5 | > 5 | 0,3 |

Die Ergebnisse in Tabelle 7 zeigen, dass sich durch die Trägerschicht die mechanischen Eigenschaften der hergestellten Schichtenverbunde deutlich verbessern. Hervorzuheben ist zusätzlich die deutlich verbesserte Haftung zum Schaumklebeband.

### Herstellung der nahtlos/endlosen Druckformen:

Aus den in den Beispielen 7a - 7f hergestellten Schichtenverbunden wurden, wie in der allgemeinen Vorschrift beschrieben, nahtlos/endlose Druckformen hergestellt. Als Träger wurde eine Onyx-Hülse der Fa. Polywest eingesetzt, zur Fixierung des Schichtenverbundes auf der Hülse wurde ein doppelseitige Schaumklebeband (Rogers SA 2520) verwendet. Diese wurden mit einer digital bebilderbaren Schicht versehen, bebildert, belichtet, ausgewaschen, getrocknet und nachbehandelt.

### Druckversuche

Der Andruck der Druckform erfolgte auf einer W&H Druckmaschine, als Bedruckstoff wurde eine PE-Folie verwendet, die Druckgeschwindigkeit betrug 150 m/min. Tabelle 8 gibt die Qualität der Druckformen hinsichtlich des Auftretens von Tape- und Plattenspalt und des Auftreten von Anlaufkanten im Druckbild wieder.

**Tabelle 8: Qualität der Druckformen**

| Schichtenverbunde aus | Tapespalt | Platten spalt | Anlaufkante |
|---|---|---|---|
| Beispiel 7a (Vergleich) | sichtbar | nicht sichtbar | sichtbar |
| Beispiel 7b | nicht sichtbar | nicht sichtbar | nicht sichtbar |
| Beispiel 7c | nicht sichtbar | nicht sichtbar | nicht sichtbar |
| Beispiel 7d | nicht sichtbar | nicht sichtbar | nicht sichtbar |
| Beispiel 7e (Vergleich) | nicht sichtbar | sichtbar | nicht sichtbar |
| Beispiel 7f (Vergleich) | nicht sichtbar | nicht sichtbar | nicht sichtbar |

## Patentansprüche

1. Verfahren zur Herstellung von fotopolymerisierbaren zylindrischen, endlos-nahtlosen Flexodruckelementen, bei dem man als Ausgangsmaterial einen Schichtenverbund umfassend mindestens
b) eine gegebenenfalls fotopolymerisierbare elastomere Trägerschicht, mindestens enthaltend ein elastomeres Bindemittel, gegebenenfalls ethylenisch ungesättigte Monomere und einen Fotoinitiator sowie gegebenenfalls weitere Additive,
c) eine fotopolymerisierbare reliefbildende Schicht, mindestens enthaltend ein elastomeres Bindemittel, ethylenisch ungesättigte Monomere und einen Fotoinitiator sowie gegebenenfalls weitere Additive,
wobei jeweils im fotopolymerisierten Zustand die reliefbildende Schicht c) eine Härte von 30 bis 70° Shore A aufweist und die elastomere Trägerschicht b) eine Härte von 75° Shore A bis 70° Shore D aufweist, wobei die Schicht b) eine um mindestens 5° Shore A größere Härte als die Schicht c) aufweist, und wobei die Bestimmung der Shore-Härte entsprechend DIN 53505 an einem Stapel von sechs 1 mm dicken Schichten erfolgt, die durch 15-minütiges vollflächiges Belichten mit UVA-Licht fotopolymerisiert worden sind,
einsetzt, und wobei das Verfahren die folgenden Schritte umfasst:
(i) Zurechtschneiden der zu verbindenden Kanten des Schichtenverbundes mittels Gehrungsschnitten,
(ii) Aufschieben und Arretieren eines Hohlzylinders auf einen drehbar gelagerten Trägerzylinder,
(iii) Aufbringen einer Haftschicht a) auf die äußere Fläche des Hohlzylinders,
(iv) Aufbringen des zurechtgeschnittenen Schichtenverbundes mit der elastomeren Trägerschicht b) auf den mit der Haftschicht versehenen Hohlzylinder, wobei die mit dem Gehrungsschnitt versehenen Enden im Wesentlichen aufeinander liegen, aber nicht überlappen,
(v) gegebenenfalls Abziehen einer Deckfolie von der fotopolymerisierbaren reliefbildenden Schicht c),
(vi) Verbinden der Schnittkanten, indem man die Oberfläche der fotopolymerisierbaren Schicht auf dem Hohlzylinder unter Erwärmen mit einer sich drehenden Kalanderwalze in Kontakt bringt, bis die Schnittkanten miteinander verbunden sind,
(vii) Abziehen des bearbeiteten Hohlzylinders vom Trägerzylinder.

2. Verfahren nach Anspruch 1, **dadurch gekennzeichnet, dass** man die Trägerschicht vor Verfahrensschritt (iii) von der von der Deckfolie abgewandten Seite her - direkt oder durch die Trägerfolie hindurch - mit aktinischem Licht vorbelichtet.

3. Verfahren nach Anspruch 1 oder 2, **dadurch gekennzeichnet, dass** die Haftschicht ein doppelseitiges Klebeband ist.

4. Hohlzylinder mit einem Schichtenverbund umfassend
a) auf dem Hohlzylinder eine Haftschicht,
b) auf der Haftschicht eine gegebenenfalls fotopolymerisierbare elastomere Trägerschicht, mindestens enthaltend ein elastomeres Bindemittel, gegebenenfalls ethylenisch ungesättigte Monomere und einen Fotoinitiator sowie gegebenenfalls weitere Additive,
c) auf der Trägerschicht eine fotopolymerisierbare reliefbildende Schicht, mindestens enthaltend ein elastomeres Bindemittel, ethylenisch ungesättigte Monomere und einen Fotoinitiator sowie gegebenenfalls weitere Additive,
wobei jeweils im fotopolymerisierten Zustand die reliefbildende Schicht c) eine Härte von 30 bis 70° Shore A aufweist und die elastomere Trägerschicht b) eine Härte von 75° Shore A bis 70° Shore D aufweist, wobei die Schicht b) eine um mindestens 5° Shore A größere Härte als die Schicht c) aufweist, und wobei die Bestimmung der Shore-Härte entsprechend DIN 53505 an einem Stapel von sechs 1 mm dicken Schichten erfolgt, die durch 15-minütiges vollflächiges Belichten mit UVA-Licht fotopolymerisiert worden sind.

5. Verwendung eines Schichtenverbundes, der in der Abfolge (1) bis (6) aufweist:
(1) eine Trägerfolie,
(2) optional eine Entklebungsschicht
(3) eine gegebenenfalls fotopolymerisierbare elastomere Trägerschicht b), mindestens enthaltend ein elastomeres Bindemittel, gegebenenfalls ethylenisch ungesättigte Monomere und einen Fotoinitiator sowie gegebenenfalls weitere Additive,
(4) eine fotopolymerisierbare reliefbildende Schicht c), mindestens enthaltend ein elastomeres Bindemittel, ethylenisch ungesättigte Monomere und einen Fotoinitiator sowie gegebenenfalls weitere Additive,
(5) optional eine Entklebungsschicht,
(6) eine Deckfolie,
wobei jeweils im fotopolymerisierten Zustand die reliefbildende Schicht c) eine Härte von 30 bis 70° Shore A aufweist und die elastomere Trägerschicht b) eine Härte von 75° Shore A bis 70° Shore D aufweist, wobei die Schicht b) eine um mindestens 5° Shore A größere Härte als die Schicht c) aufweist, und wobei die Bestimmung der Shore-Härte entsprechend DIN 53505 an einem Stapel von sechs 1 mm dicken Schichten erfolgt, die durch 15-minütiges vollflächiges Belichten mit UVA-Licht fotopolymerisiert worden sind,
in dem Verfahren gemäß einem der Ansprüche 1 bis 3.

## Claims

1. Method for producing photopolymerisable, cylindrical, seamless flexographic printing elements, in which method a layer composite comprising at least
b) an optionally photopolymerisable elastomeric carrier layer, at least containing an elastomeric binder, optionally ethylenically unsaturated monomers and a photoinitiator and optionally further additives,
c) a photopolymerisable relief-forming layer, at least containing an elastomeric binder, ethylenically unsaturated monomers and a photoinitiator and optionally further additives,
wherein in the photopolymerised state the relief-forming layer c) has a hardness of 30 to 70° Shore A and the elastomeric carrier layer b) has a hardness of 75° Shore A to 70° Shore D, wherein layer b) has a greater hardness than layer c) by at least 5° Shore A, and wherein the Shore hardness is determined in accordance with DIN 53505 on a stack of six 1 mm thick layers that have been photopolymerised by exposure to UVA light over the entire surface thereof for 15 minutes,
is used as the starting material, and wherein the method comprises the following steps:
(i) trimming the edges of the layer composites to be connected by means of mitre cuts,
(ii) pushing and locking a hollow cylinder onto a rotatably mounted carrier cylinder,
(iii) applying an adhesive layer a) to the outer surface of the hollow cylinder,
(iv) applying the trimmed layer composite with the elastomeric carrier layer b) to the hollow cylinder provided with the adhesive layer, wherein the ends provided with the mitre cut lie substantially one on top of the other, but not do not overlap,
(v) optionally pulling off a cover film from the photopolymerisable relief-forming layer c),
(vi) joining the cut edges by bringing the surface of the photopolymerisable layer on the hollow cylinder into contact with a rotating calender roller while heating, until the cut edges are interconnected,
(vii) pulling off the processed hollow cylinder from the carrier cylinder.

2. Method according to claim 1, **characterised in that**, before method step (iii), the carrier layer is pre-exposed to actinic light from the side facing away from the cover film, directly or through the carrier film.

3. Method according to either claim 1 or claim 2, **characterised in that** the adhesive layer is a double-sided adhesive tape.

4. Hollow cylinder having a layer composite comprising
a) an adhesive layer on the hollow cylinder,
b) on the adhesive layer, an optionally photopolymerisable elastomeric carrier layer, at least containing an elastomeric binder, optionally ethylenically unsaturated monomers and a photoinitiator and optionally further additives,
c) on the carrier layer, a photopolymerisable relief-forming layer, at least containing an elastomeric binder, ethylenically unsaturated monomers and a photoinitiator and optionally further additives,
wherein in the photopolymerised state the relief-forming layer c) has a hardness of 30 to 70° Shore A and the elastomeric carrier layer b) has a hardness of 75° Shore A to 70° Shore D, wherein layer b) has a greater hardness than layer c) by at least 5° Shore A, and wherein the Shore hardness is determined in accordance with DIN 53505 on a stack of six 1 mm thick layers that have been photopolymerised by exposure to UVA light over the entire surface thereof for 15 minutes.

5. Use of a layer composite, which comprises, in the sequence (1) to (6):
(1) a carrier film,
(2) optionally a detackifying layer
(3) an optionally photopolymerisable elastomeric carrier layer b), at least containing an elastomeric binder, optionally ethylenically unsaturated monomers and a photoinitiator and optionally further additives,
(4) a photopolymerisable relief-forming layer c), at least containing an elastomeric binder, ethylenically unsaturated monomers and a photoinitiator and optionally further additives,
(5) optionally a detackifying layer,
(6) a cover film,
wherein in the photopolymerised state the relief-forming layer c) has a hardness of 30 to 70° Shore A and the elastomeric carrier layer b) has a hardness of 75° Shore A to 70° Shore D, wherein layer b) has a greater hardness than layer c) by at least 5° Shore A, and wherein the Shore hardness is determined in accordance with DIN 53505 on a stack of six 1 mm thick layers that have been photopolymerised by exposure to UVA light over the entire surface thereof for 15 minutes,
in the method according to any of claims 1 to 3.

## Revendications

1. Procédé de fabrication d'éléments d'impression flexographique sans soudure sans fin, cylindrique photopolymérisable, dans lequel on utilise comme matériau de départ un composite multi-couche comprenant au moins
b) une couche support élastomère éventuellement photopolymérisable, contenant au moins un liant élastomère, éventuellement des monomères éthyléniquement insaturés et un photo-initiateur ainsi qu'éventuellement d'autres additifs,
c) une couche de formation de relief photopolymérisable, contenant au moins un liant élastomère, des monomères éthyléniquement insaturés et un photo-initiateur ainsi qu'éventuellement d'autres additifs,
dans lequel respectivement dans l'état photopolymérisé, la couche de formation de relief c) présente une dureté de 30 à 70° Shore A et la couche support élastomère b) présente une dureté de 75° Shore A à 70° Shore D, dans lequel la couche b) présente une dureté supérieure d'au moins 5° Shore A à celle de la couche c), et dans lequel la détermination de la dureté Shore est effectuée selon DIN 53505 au niveau d'une pile de six couches de 1 mm d'épaisseur qui ont été photopolymérisées par exposition sur toute la surface de 15 minutes à une lumière UVA,
et dans lequel le procédé comporte les étapes suivantes :
(i) le sectionnage des arêtes à relier du composite multi-couche au moyen de coupes en biais,
(ii) l'enfilage et l'arrêt d'un cylindre creux sur un cylindre porteur logé de manière à pouvoir tourner,
(iii) l'application d'une couche adhésive a) sur la surface extérieure du cylindre creux,
(iv) l'application du composite multi-couche sectionné avec la couche support b) élastomère sur le cylindre creux pourvu de la couche adhésive, dans lequel les extrémités pourvues de la coupe en biais reposent sensiblement l'une sur l'autre mais ne se recouvrent pas,
(v) l'éventuel retrait d'un film de recouvrement de la couche de formation de relief c) photopolymérisable,
(vi) la liaison des arêtes de coupe, en ce qu'on amène en contact la surface de la couche photopolymérisable sur le cylindre creux en chauffant avec un rouleau de calandre rotatif jusqu'à ce que les arêtes de coupe soient reliées entre elles,
(vii) le retrait du cylindre creux usiné du cylindre porteur.

2. Procédé selon la revendication 1, **caractérisé en ce qu'**on préexpose la couche support avant l'étape de procédé (iii) du côté éloigné du film de recouvrement, directement ou au travers du film porteur, à de la lumière actinique.

3. Procédé selon la revendication 1 ou 2, **caractérisé en ce que** la couche adhésive est une bande adhésive double face.

4. Cylindre creux avec un composite multi-couche comprenant
a) sur le cylindre creux une couche adhésive,
b) sur la couche adhésive une couche support élastomère éventuellement photopolymérisable, contenant au moins un liant élastomère, éventuellement des monomères éthyléniquement insaturés et un photo-initiateur ainsi qu'éventuellement d'autres additifs,
c) sur la couche support une couche de formation de relief photopolymérisable, contenant au moins un liant élastomère, des monomères éthyléniquement insaturés et un photo-initiateur ainsi qu'éventuellement d'autres additifs,
dans lequel respectivement dans l'état photopolymérisé, la couche de formation de relief c) présente une dureté de 30 à 70° Shore A et la couche support élastomère b) présente une dureté de 75° Shore A à 70° Shore D, dans lequel la couche b) présente une dureté supérieure d'au moins 5° Shore A à celle de la couche c), et dans lequel la détermination de la dureté Shore est effectuée selon DIN 53505 au niveau d'une pile de six couches de 1 mm d'épaisseur qui ont été photopolymérisées par exposition sur toute la surface de 15 minutes à une lumière UVA.

5. Utilisation d'un composite multi-couche qui présente dans l'ordre (1) à (6) :
(1) un film porteur,
(2) en option une couche de décollage,
(3) une couche support b) élastomère éventuellement photopolymérisable, contenant au moins un liant élastomère, éventuellement des monomères éthyléniquement insaturés et un photo-initiateur ainsi qu'éventuellement d'autres additifs,
(4) une couche de formation de relief photopolymérisable c), contenant au moins un liant élastomère, des monomères éthyléniquement insaturés et un photo-initiateur ainsi qu'éventuellement d'autres additifs,
(5) en option une couche de décollage,
(6) un film de recouvrement,
dans lequel respectivement dans l'état photopolymérisé, la couche de formation de relief c) présente une dureté de 30 à 70° Shore A et la couche support élastomère b) présente une dureté de 75° Shore A à 70° Shore D, dans lequel la couche b) présente une dureté supérieure d'au moins 5° Shore A à celle de la couche c), et dans lequel la détermination de la dureté Shore est effectuée selon DIN 53505 au niveau d'une pile de six couches de 1 mm d'épaisseur qui ont été photopolymérisées par exposition sur toute la surface de 15 minutes à une lumière UVA,
dans le procédé selon l'une des revendications 1 à 3.
